# DEMANDE DE BREVET EUROPEEN

(11) **EP 1 925 909 A1**
(43) Date de publication de la demande: **28.05.2008**
(21) Numéro de dépôt: 07121205.4
(22) Date de dépôt: 21.11.2007
(51) Int. Cl.: G01B 11/255, G03F 1/14, H01L 21/66

(54) **Dispositif de nettoyage et de dépollution d'un objet à environnement confiné non étanche limité par une paroi à membrane souple**

(30) Priorité: 21.11.2006 FR 0655009; 29.01.2007 FR 0752936
(71) Demandeur: Alcatel Lucent, 75008 Paris (FR)
(72) Inventeur: Favre, Arnaud, 74000, ANNECY (FR); Foray, Jean-Marie, 74000, ANNECY (FR)
(74) Mandataire: Sciaux, Edmond

(57) **Abrégé**

Le dispositif de nettoyage et de dépollution d'un objet, à environnement confiné non étanche limité par une paroi à membrane souple, selon l'invention comprend :
- une enceinte de nettoyage et de dépollution étanche munie d'une portion de paroi transparente par laquelle peuvent entrer et sortir des faisceaux lumineux interagissant avec la membrane souple,
- des moyens de pompage,
- une source de gaz de purge,
- une entrée pour relier l'enceinte à la source de gaz de purge,
- une sortie pour relier l'enceinte aux moyens de pompage,
- des moyens de commande pour piloter les moyens de pompage et la source de gaz de purge en fonction d'un signal fourni par un dispositif de mesure sans contact de la déformation d'une membrane souple, transparente, fixe à ses extrémités et soumise à une pression différentielle, comprend des moyens pour générer un faisceau lumineux incident et pour le diriger obliquement vers la membrane, et des moyens pour recevoir et isoler le faisceau lumineux réfléchi par la membrane et pour en mesurer le déplacement.

## Description

La présente invention concerne un dispositif de nettoyage et de dépollution d'un objet à environnement confiné non étanche limité par une paroi à membrane souple au moyen d'un dispositif de mesure sans contact de la déformation d'une membrane.

Des membranes souples sont utilisées notamment dans l'industrie du semi-conducteur. II peut s'agir par exemple des pellicules de protection des photomasques.

Un photomasque est équivalent à un négatif en photographie, c'est-à-dire qu'il contient sur un support généralement appelé blank un motif destiné à être reproduit sur un substrat. Il est utilisé pour transmettre, selon le motif choisi, un rayonnement lumineux qui vient frapper une couche photosensible sur un substrat semi-conducteur. Dans le masque, des zones actives transmettent le rayonnement, tandis que des zones inactives arrêtent le rayonnement. Les pollutions dans une zone active ont un effet direct sur le motif imprimé sur le substrat : le motif est alors imprimé avec un défaut, une forme erronée de motif gravé. Les pollutions peuvent aussi avoir un effet indirect sur l'image imprimée si elles interviennent en dehors des zones actives. Les problèmes engendrés peuvent être par exemple la diminution du contraste ou encore la réduction de la transmission du photomasque.

Dans l'industrie du semi-conducteur, on cherche en permanence à réduire la dimension des motifs à imprimer afin d'obtenir des composants électroniques toujours plus petits et moins coûteux. Les dimensions des motifs à imprimer se réduisant, les exigences en matière de pollution deviennent par conséquent de plus en plus strictes. Le photomasque est donc un élément clé, cher et complexe que l'on cherche à conserver propre et opérationnel.

Un photomasque est constitué d'un support dont la surface reçoit le motif à reproduire. Il convient de protéger le motif pour empêcher le dépôt de particules polluantes. Pour cela, à la fin de son processus de fabrication, le photomasque est nettoyé et inspecté. S'il est propre et sans défaut, le photomasque est pelliculé et est prêt à être utilisé, stocké ou transporté.

La pellicule de protection doit protéger le photomasque pendant sa durée de vie. Elle consiste en une membrane optique (surfaces multicouches) ayant une bonne transmission optique et un impact réduit sur les rayons optiques qui la traversent.

Cette pellicule de protection est déposée du côté de la face active du photomasque et est séparée de celle-ci par un espace d'environ 6 mm assuré par un élément communément appelé support de film. Les particules polluantes éventuellement présentes dans l'environnement du photomasque vont ainsi se déposer sur la pellicule protectrice au lieu de se déposer sur la zone active du photomasque. Les polluants, tenus à l'écart de la zone active du photomasque, se trouvent ainsi en dehors de la zone de focalisation du rayonnement lumineux lors de l'utilisation du photomasque, et ne produisent donc pas une image imprimée sur les substrats semi-conducteurs. La pellicule ne protège pas complètement le photomasque des polluants mais permet de réduire leur impact sur la qualité de l'image.

La pellicule de protection est le plus souvent collée sur le pourtour de la partie active du masque et est espacée de celle-ci par le support de film. L'atmosphère sous la pellicule est confinée, mais pas entièrement isolée de l'atmosphère extérieure. On prévoit en effet un passage de faible dimension, par exemple un filtre de faible conductance, qui traverse le support de film pour équilibrer autant que possible les pressions gazeuses de part et d'autre de la pellicule.

Ainsi les éléments constituant le photomasque, à savoir le support de motifs (blank), le support de film et la pellicule de protection, forment un environnement confiné non étanche.

On sait depuis peu que des polluants peuvent être présents sous la pellicule de protection. Des phénomènes de croissance cristalline au niveau de la zone active du photomasque peuvent être observés. Cette pollution a un effet direct sur la qualité des motifs reproduits. Sa situation sous la pellicule rend le nettoyage difficile. Le nettoyage d'un photomasque déjà muni de sa pellicule est jusqu'à présent long, complexe et coûteux. Il est nécessaire de retirer la pellicule puis de la redéposer. Cette opération doit être effectuée par les fabricants de photomasques et non par les utilisateurs, ce qui provoque une perte de temps ainsi que des coûts supplémentaires importants pour la gestion des stocks liée à une durée de vie raccourcie des photomasques.

De façon classique, la pellicule de protection protégeant la zone active du photomasque a pour dimensions approximatives 10 cm x 10 cm et a une épaisseur de quelques microns. Ces dimensions rendent cette membrane extrêmement fragile. Un simple contact par appui mécanique aurait pour conséquence de détériorer voire détruire cette pellicule de protection.

Ainsi, le contrôle de la déformation de cette membrane ne peut être effectué que grâce à une mesure sans contact.

Pour stocker ou transporter les photomasques, ceux-ci sont généralement introduits dans des enceintes étanches, le plus souvent en plastique. Ces enceintes ne sont généralement plus étanches à l'usage. C'est pourquoi il est important de nettoyer et dépolluer les objets mis à l'intérieur.

Pour cela, on fait le vide dans l'atmosphère intérieure de ces enceintes étanches que l'on peut purger en injectant un gaz neutre. L'avantage de ce gaz neutre est qu'il ne se combinera pas avec d'autres gaz résiduels (dégazage des parois ou autre), en polluant l'atmosphère.

Au cours de ces étapes de nettoyage et de dépollution, on fait donc varier la pression gazeuse de l'atmosphère qui entoure les objets tels que les photomasques.

Or le filtre à faible conductance prévu dans le support de film n'a pas une conductance suffisante pour assurer un équilibre naturel des pressions de part et d'autre de la membrane si la pression environnante varie trop rapidement. Il en résulte alors l'établissement d'une pression différentielle qui force la membrane vers l'extérieur ou vers l'intérieur du photomasque, avec un risque important de rupture de la membrane.

Afin de limiter les écarts de pression de part et d'autre de la membrane, et ainsi de préserver la membrane, on a jusqu'à présent utilisé des moyens de pompage et de purge adaptés qui réalisent un pompage lent de l'enceinte étanche et une introduction lente des gaz de purge. Ceci a pour effet que le temps nécessaire pour effectuer ces étapes de nettoyage et de dépollution est très long.

Les écarts de pression de part et d'autre de la pellicule de protection sont dangereux pour cette membrane très fragile. Ils peuvent la détériorer, voire la détruire. Pour préserver la pellicule de protection du photomasque, il est nécessaire de ne pas dépasser la limite de déformation élastique de la membrane.

Dans le commerce, il existe des capteurs pour surveiller sans contact la déformation ou le déplacement d'un objet.

Un premier capteur connu utilise les ultrasons pour mesurer la déformation ou le déplacement d'un objet. L'émetteur envoie un train d'ondes qui va se réfléchir sur l'objet à détecter et ensuite revenir à la source. Le temps mis pour parcourir un aller-retour permet de déterminer la distance de l'objet par rapport à la source.

Ce type de capteur permet de détecter tout type de matériau sauf les objets absorbant les ondes sonores. Cependant, absolument aucun fonctionnement n'est possible dans le vide. Ainsi on ne pourra pas utiliser de capteurs à ultrasons pour mesurer la déformation de la pellicule d'un photomasque pendant les étapes où il est soumis à une basse pression.

Dans le commerce, un second type de capteur pour mesurer une déformation est disponible, basé sur la détection laser. Cependant, ce type de capteur donne uniquement un résultat binaire sur la planéité de la membrane, et ne permet pas de quantifier la déformation non nulle d'une membrane.

Le problème posé par la présente invention est de quantifier sans contact la déformation d'une membrane soumise à une pression différentielle dans une atmosphère à basse pression.

L'invention propose un dispositif et un procédé de nettoyage et de dépollution d'objets qui définissent un environnement confiné non étanche limité par une paroi souple, en évitant de dégrader la membrane tout en réduisant sensiblement la durée du processus de nettoyage et de dépollution.

Pour atteindre ces buts ainsi que d'autres, l'invention propose un dispositif de nettoyage et de dépollution d'un objet à environnement confiné non étanche limité par une paroi à membrane souple, comprenant :
- une enceinte de nettoyage et de dépollution étanche munie d'une portion de paroi transparente par laquelle peuvent entrer et sortir des faisceaux lumineux interagissant avec la membrane souple,
- des moyens de pompage,
- une source de gaz de purge, contenant un gaz ou mélange de gaz de purge,
- une entrée pour relier à la source de gaz de purge l'enceinte de nettoyage et de dépollution,
- une sortie pour relier aux moyens de pompage l'enceinte de nettoyage et de dépollution,
- des moyens de commande pour piloter les moyens de pompage et la source de gaz de purge,
dans lequel les moyens de commande pilotent les moyens de pompage et/ou la source de gaz de purge en fonction d'un signal fourni par un dispositif de mesure sans contact de la déformation d'une membrane souple, transparente, fixe à ses extrémités et soumise à une pression différentielle, comprenant des moyens pour générer un faisceau lumineux incident et le diriger obliquement vers la membrane, et des moyens pour recevoir et isoler le faisceau lumineux réfléchi par la membrane et pour en mesurer le déplacement.

Ce dispositif de mesure a pour effet de fournir, sans contact avec la membrane, une mesure fiable de la déformation de la membrane même lorsque celle-ci est dans une atmosphère à basse pression. Ce qui ne pouvait être effectué avec les dispositifs de l'art antérieur.

En pratique, on peut prévoir que les moyens pour générer un faisceau lumineux incident comprennent une source laser, avantageusement émettant un rayonnement à une longueur d'onde d'environ 900 nm. Cela permet d'accroître la sensibilité du dispositif. De préférence le faisceau lumineux incident fait avec la surface de la membrane un angle d'incidence α d'environ 56°, de façon que la réflexion partielle sur la membrane ait une intensité lumineuse optimale.

Le faisceau lumineux incident est de préférence dirigé vers la zone de déformation maximale de la membrane (zone centrale de la membrane) de façon précise grâce à l'utilisation du laser. La précision du laser est due à la cohérence spatiale (en tout point du faisceau, la phase est la même) et à la cohérence temporelle (conservation de la phase pendant une durée de cohérence) caractéristique du laser.

Le faisceau lumineux incident interagit alors avec (est réfléchi par) la zone centrale de la membrane.

Les moyens pour recevoir et isoler le faisceau lumineux réfléchi sont choisis au regard des moyens pour générer le faisceau lumineux incident.

En pratique, les moyens pour recevoir et isoler le faisceau lumineux réfléchi peuvent comprendre une matrice ordonnée de récepteurs photoélectriques adaptée pour recevoir les faisceaux réfléchis par les différentes surfaces se trouvant sur le chemin du faisceau lumineux incident, comprenant le faisceau réfléchi par la membrane, et pour produire des signaux électriques images de l'amplitude et de la position de l'énergie lumineuse atteignant la matrice.

De plus, les moyens pour recevoir et isoler le faisceau lumineux réfléchi analysent les signaux électriques issus de la matrice, distinguent, par sa position relative, le signal correspondant au faisceau réfléchi par la membrane, et produisent en sortie un signal correspondant à la position du faisceau lumineux réfléchi par la membrane.

Ce dispositif de mesure est utilisé dans un dispositif de nettoyage et de dépollution d'objets, tels que des photomasques, selon l'invention. Ce dispositif de mesure peut être utilisé pour contrôler la déformation d'une pellicule de protection d'un photomasque dans une atmosphère à pression variable ou bien pour limiter les variations de pression de l'atmosphère entourant un photomasque à pellicule de protection. Dans le premier cas, on peut s'assurer que la déformation ne risque pas d'entraîner une dégradation de la pellicule. Dans le deuxième cas, en asservissant à la déformation de la membrane les variations de pression que l'on fait subir au photomasque, on limite les risques de dégradation de la membrane.

Selon un autre aspect, l'invention prévoit un procédé de nettoyage et de dépollution d'un objet à environnement confiné non étanche limité par une paroi à membrane souple, comprenant les étapes suivantes :
- on place l'objet à environnement confiné non étanche dans une enceinte étanche comprenant des moyens pour injecter un gaz ou mélange de gaz de purge et des moyens de pompage,
- on mesure en permanence la déformation de la membrane à l'aide d'un dispositif de mesure sans contact de la déformation d'une membrane souple (1), transparente, fixe à ses extrémités et soumise à une pression différentielle, qui comprend des moyens (3) pour générer un faisceau lumineux incident (I) et le diriger obliquement vers la membrane (1), et des moyens (5) pour recevoir et isoler le faisceau lumineux (4) réfléchi par la membrane (1) et pour en mesurer le déplacement,
- on pompe le gaz contenu dans l'enceinte étanche et le gaz contenu dans l'espace intérieur de l'environnement confiné non étanche, et/ou on introduit un gaz de purge dans l'enceinte étanche et dans l'espace intérieur de l'objet à environnement confiné non étanche,
- on contrôle le pompage et/ou l'introduction de gaz de purge en fonction du signal donné par le capteur, de manière à conserver la déformation de la membrane en deçà d'une limite de déformation admissible.

On comprend que le temps nécessaire pour nettoyer et dépolluer un photomasque dépend essentiellement des temps de pompage et de purge. Ces temps dépendent directement de la déformation admise de la membrane. Plus la déformation admise est faible, plus la pression différentielle qui en est la cause de part et d'autre de la membrane doit être faible, et plus les variations de la pression environnante doivent être lentes. Les temps de pompage et de purge sont alors longs. C'est la solution nécessairement choisie avec les dispositifs connus qui ne permettent pas le contrôle des déformations de la membrane.

A l'inverse, le procédé selon l'invention permet d'optimiser le temps de traitement tout en préservant la membrane ou pellicule protectrice d'une déformation excessive, car on peut admettre sans risque des déformations sensibles mais non destructrices de la membrane, ce qui permet des variations plus rapides de la pression environnante.

D'autres objets, caractéristiques et avantages de la présente invention ressortiront de la description suivante de modes de réalisation particuliers, faite en relation avec les figures jointes, parmi lesquelles :
- la figure 1 est une vue schématique générale d'un dispositif de mesure selon l'invention ;
- la figure 2 est une vue schématique détaillée d'une utilisation du dispositif de mesure selon l'invention ; et
- la figure 3 est un graphique représentant des variations temporelles de la déformation d'une membrane de photomasque et de la pression différentielle de part et d'autre de la membrane.

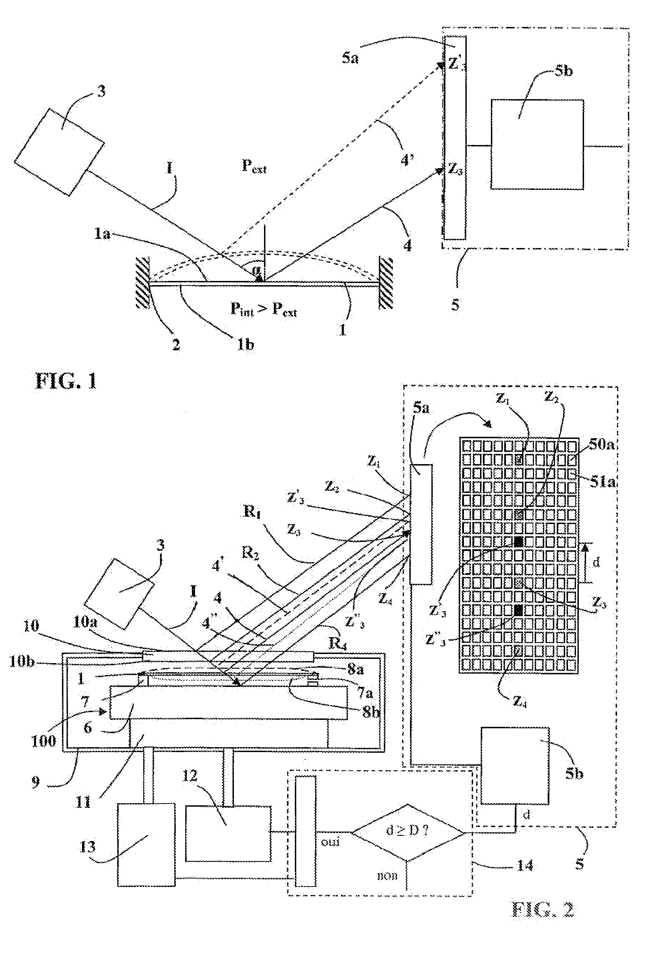

On considère la figure 1, qui illustre schématiquement un dispositif de mesure sans contact de la déformation d'une membrane 1, ci-après appelé dispositif de mesure selon l'invention.

La membrane 1 est fixée à ses extrémités par des moyens de fixation 2. Sa partie centrale est libre.

Des moyens 3 génèrent un faisceau lumineux incident l. Le faisceau lumineux incident l est dirigé vers la zone de déformation maximale de la membrane 1. Le faisceau lumineux incident l percute la membrane 1. Le faisceau lumineux incident l fait avec la surface de la membrane 1 un angle d'incidence α d'environ 56°, de façon que la réflexion partielle sur la membrane 1 ait une intensité lumineuse optimale.

La membrane 1 a une épaisseur de quelques microns. Le faisceau lumineux incident I interagit avec la membrane 1 et se réfléchit. Du fait de la très faible épaisseur de la membrane, les deux rayons réfléchis (l'un étant le rayon réfléchi par la face supérieure 1a de la membrane et le second étant le rayon réfléchi par la face inférieure 1b de la membrane) sont considérés comme un seul rayon réfléchi 4.

Le rayon réfléchi 4 percute en Z₃ des moyens 5 pour recevoir et isoler le faisceau lumineux 4 réfléchi par la membrane 1.

Lorsque la membrane 1 n'est pas soumise à une pression différentielle, elle reste plane. Cependant, lorsque la pression Pₑₓₜ s'appliquant sur la face supérieure 1a de la membrane 1 est différente de la pression Pᵢₙₜ s'appliquant sur la face inférieure 1 b de la membrane 1, la membrane 1 se déforme.

Dans le cas où Pₑₓₜ est supérieure à Pᵢₙₜ, la membrane 1 se déforme vers le bas. Si Pᵢₙₜ est supérieure à Pₑₓₜ, la membrane 1 se déforme vers le haut, tel que cela est représenté par les pointillés sur la figure 1. Dans ce dernier cas, le rayon incident I interagit avec la membrane 1 un peu avant la zone de déformation maximale. Le rayon réfléchi 4' (représenté en pointillés sur la figure 1) va percuter en Z'₃ les moyens 5 pour recevoir et isoler le faisceau lumineux réfléchi par la membrane 1.

Les moyens 5 pour recevoir et isoler le faisceau lumineux réfléchi par la membrane 1 permettent de déterminer la déformation de la membrane 1 en fonction du déplacement de la zone d'impact Z₃ du rayon réfléchi 4.

On a illustré sur la figure 1 que ces moyens 5 pour recevoir et isoler le faisceau lumineux réfléchi par la membrane 1 comprennent un premier élément 5a sensible au rayonnement lumineux et à sa position, et un second élément 5b pour analyser les signaux de présence et de position de rayonnement lumineux.

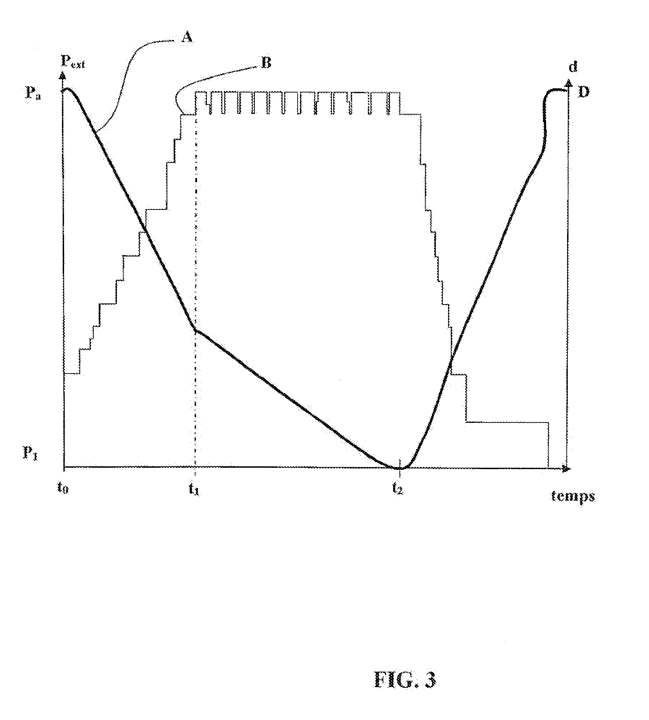

La figure 2, est une vue schématique plus détaillée du dispositif de mesure selon l'invention, illustrant son utilisation particulière pour contrôler la déformation d'une pellicule protectrice d'un photomasque dans une atmosphère à pression variable.

Un photomasque 100 est constitué d'un support 6, d'un support de film 7 comprenant une fuite 7a, d'une pellicule de protection séparée de la zone active du support 6 grâce au support de film 7.

Dans le cas décrit sur la figure 2, la pellicule de protection du photomasque constitue une membrane souple telle que la membrane 1 de la figure 1. Ainsi, dans la suite de cette description, la pellicule de protection du photomasque 100 sera désignée par l'expression membrane 1.

Le photomasque 100 constitue un objet à environnement confiné non étanche. L'environnement confiné est le volume enfermé entre la membrane 1, le support de film 7 et le support 6.

Le photomasque 100 est placé sur un support 11 dans une enceinte étanche 9 constituée de trois parois opaques (les parois latérales et la paroi inférieure) et d'une paroi supérieure munie d'une fenêtre transparente ou hublot 10.

L'enceinte étanche 9 est connectée à des moyens de pompage 12 aptes à pomper les gaz de l'atmosphère intérieure de l'enceinte étanche 9, et à des moyens 13 de fourniture de gaz.

Le premier élément 5a sensible au rayonnement lumineux et à sa position reçoit différents faisceaux lumineux réfléchis. Le second élément 5b analyse les signaux de présence et de position fournis par le premier élément 5a, et isole les signaux relatifs au rayon réfléchi 4 provenant de la membrane 1.

En pratique, une structure du premier élément 5a des moyens 5 pour recevoir et isoler le faisceau lumineux réfléchi par la membrane est illustrée en vue de face sur la partie droite de la figure 2. Dans cet exemple le premier élément 5a comprend une matrice ordonnée de récepteurs photoélectriques élémentaires tels que les récepteurs 50a et 51 a, orientés et positionnés pour recevoir de manière distincte les faisceaux lumineux réfléchis par les différentes surfaces se trouvant sur le chemin du faisceau lumineux incident I. Les récepteurs photoélectriques élémentaires produisent chacun un signal électrique dont l'amplitude est fonction de l'énergie lumineuse qui l'atteint.

Les moyens 3 pour générer un faisceau lumineux incident génèrent un faisceau lumineux incident I qui interagit avec la zone centrale de la membrane 1 du photomasque 100.

Sur son chemin le faisceau lumineux incident l rencontre la face supérieure 10a du hublot 10, puis la face inférieure 10b du hublot 10, puis la membrane 1 et enfin le support 6.

Ces faces réfléchissent chacune une partie du faisceau lumineux incident l. Le faisceau R₁ réfléchi par la face supérieure 10a du hublot 10 percute en Z₁ le premier élément 5a des moyens 5 pour recevoir et isoler le faisceau lumineux réfléchi par la membrane 1.

Le faisceau R₂ réfléchi par la face inférieure 10b du hublot 10 percute en Z₂ le premier élément 5a des moyens 5 pour recevoir et isoler le faisceau lumineux réfléchi par la membrane 1.

Le faisceau 4 réfléchi par la membrane 1 percute en Z₃ le premier élément 5a des moyens 5 pour recevoir et isoler le faisceau lumineux réfléchi par la membrane 1.

Le faisceau R₄ réfléchi par le support 6 percute en Z₄ le premier élément 5a des moyens 5 pour recevoir et isoler le faisceau lumineux réfléchi par la membrane 1.

La matrice ordonnée de récepteurs photoélectriques constituant le premier élément 5a est adaptée pour pouvoir distinguer les impacts Z₁, Z₂, Z₃ et Z₄. En pratique, les récepteurs photoélectriques élémentaires tels que 50a et 51 a seront disposés côte à côte et auront un diamètre nettement inférieur à l'écart entre les impacts Z₁-Z₄.

Le second élément 5b des moyens 5 pour recevoir et isoler le faisceau lumineux réfléchi par la membrane 1 scrute les signaux électriques issus de la matrice 5, distingue, par la position relative des récepteurs photoélectriques élémentaires tels que 50a et 51a qui les reçoivent, les signaux correspondant au faisceau 4 réfléchi par la membrane 1, et produit en sortie un signal d correspondant à la position de l'impact Z₃ du faisceau lumineux 4 réfléchi par la membrane 1.

En pratique, on a obtenu de bons résultats en utilisant une matrice 5 avec une seule colonne, dans la mesure où le faisceau lumineux incident I interagit avec la zone centrale de la membrane 1 lorsque celle-ci est au repos.

Dans le mode de réalisation illustré sur la figure 2, le dispositif de mesure selon l'invention est associé à un dispositif permettant le nettoyage et la dépollution du photomasque 100.

Le dispositif de nettoyage et de dépollution comprend des moyens de commande 14, comportant un processeur associé à un programme de commande enregistré dans une mémoire. Le programme enregistré comporte des séquences de programme d'extraction de gaz par pompage et des séquences de programme d'introduction de gaz de purge. Les moyens de commande 14 pilotent les moyens de pompage 12 et les moyens de fourniture de gaz 13.

Lors des séquences de pompage ou d'introduction de gaz, la membrane 1 subit des pressions différentes de part et d'autre de ses faces. Pᵢₙₜ est la pression de l'atmosphère dans l'environnement confiné du photomasque 100, c'est-à-dire la pression gazeuse entre la face inférieure de la membrane 1 et la face supérieure du support 6. Pₑₓₜ est la pression gazeuse autour du photomasque 100 dans l'enceinte étanche 9. Ces pressions différentes déforment la membrane 1.

Lors d'une étape préliminaire, en pression Pₑₓₜ stable, la position de l'impact Z₃ est mémorisée par exemple par le second élément 5b des moyens 5 pour recevoir et isoler le faisceau lumineux réfléchi par la membrane 1.

Lors d'une première étape, on veut faire le vide dans l'enceinte étanche 9. Les moyens de pompage 12 baissent la pression Pₑₓₜ. La face inférieure de la membrane 1 se trouve à Pᵢₙₜ et sa face extérieure à Pₑₓₜ plus basse. La membrane 1 va alors se déformer vers le haut (ou vers l'extérieur du photomasque). Cette déformation est illustrée par des pointillés 8a. La fuite 7a tend à réduire l'écart de pression de part et d'autre de la membrane 1, mais cela ne suffit pas.

La membrane 1 déformée réfléchit le faisceau lumineux incident I, et le faisceau 4' réfléchi va percuter en Z'₃ le premier élément 5a des moyens 5 pour recevoir et isoler le faisceau lumineux réfléchi par la membrane 1.

Le second élément 5b des moyens 5 pour recevoir et isoler le faisceau lumineux réfléchi par la membrane 1, qui a pour rôle de faire le tri entre les impacts Z₁, Z₂, Z'₃ et Z₄, permet de ne considérer que l'impact Z'₃, seul point d'impact correspondant à la membrane 1. Le dispositif de mesure selon l'invention fournit ainsi le signal électrique correspondant à la position de l'impact Z'₃. Ce signal est comparé par les moyens de commande 14 à la position de l'impact initial Z₃, qui est en mémoire, pour déterminer le déplacement d de l'impact Z₃. Ce déplacement est l'image de la déformation de la membrane 1.

Un test est ensuite effectué par les moyens de commande 14 sur la déformation d de la membrane 1. Pour cela, le programme des moyens de commande 14 contient un algorithme selon lequel:
- lorsque la déformation d de la membrane souple 1 mesurée par le capteur est inférieure à une limite D de déformation admissible, alors la séquence de pompage ou d'introduction de gaz de purge se déroule normalement, selon les autres instructions contenues dans le programme,
- lorsque la déformation d de la membrane souple 1 mesurée par le capteur est au moins égale à la limite D de déformation admissible, la séquence de pompage ou d'introduction de gaz de purge est modifiée pour réduire volontairement la vitesse de variation de pression gazeuse Pₑₓₜ dans l'enceinte étanche 9, afin de réduire ou de ne pas augmenter la déformation d de la membrane souple 1.

Ainsi, si la déformation d de la membrane 1 est supérieure à la déformation admissible D, le pompage est modifié de façon à réduire la déformation d de la membrane 1.

La limite de déformation admissible D est choisie inférieure au seuil de déformation élastique de la membrane 1. Elle dépend de la membrane 1, du pompage, du procédé, et est déterminée par l'expérience.

Lors de la seconde étape du procédé de nettoyage et de dépollution, on purge l'environnement de l'enceinte étanche 9 par introduction d'un gaz neutre, avantageusement l'argon.

Ainsi Pₑₓₜ devient supérieure à Pᵢₙₜ, la membrane 1 se déforme alors vers le bas, comme indiqué par la forme en pointillés très serrés 8b.

La membrane 1 déformée réfléchit le faisceau lumineux incident I, le faisceau 4" réfléchi va percuter en Z"₃ le premier élément 5a des moyens 5 pour recevoir et isoler le faisceau lumineux réfléchi par la membrane 1.

La suite du processus est similaire à celui décrit pour la première étape, à la différence que l'on contrôle alors les moyens de fourniture de gaz 13 en fonction de la déformation mesurée de la membrane 1.

La figure 3 illustre le fonctionnement décrit ci-dessous du dispositif de la figure 2, au cours d'une procédure de nettoyage par purge. La courbe A illustre la variation temporelle de la pression Pₑₓₜ dans l'enceinte étanche 9. La courbe B illustre la variation temporelle du signal de position de l'impact Z₃, qui est l'image de la position de la zone de déformation maximale de la membrane 1.

A l'instant initial t₀, la pression Pₑₓₜ dans l'enceinte étanche 9 est la pression atmosphérique Pₐ. Les moyens de commande 14 font agir les moyens de pompage 12 selon une séquence de programme normale de pompage. Le dispositif de mesure de déformation contrôle en permanence la déformation de la membrane 1, et produit un signal de position (courbe B) image de cette déformation. Jusqu'à l'instant t₁, la pression Pₑₓₜ décroît selon une pente déterminée par les paramètres de pompage choisis par le programme enregistré des moyens de commande 14. La décroissance assez rapide de la pression Pₑₓₜ provoque l'apparition d'une pression différentielle, la pression intérieure Pᵢₙₜ décroissant moins vite que Pₑₓₜ. II en résulte une déformation d croissante de la membrane 1 (courbe B).

A l'instant t₁, la courbe B de déformation de la membrane 1 atteint la limite D de déformation admissible. Les moyens de commande 14 détectent alors cet évènement, par l'algorithme du programme, et modifient l'actionnement des moyens de pompage 12, par exemple en réduisant la vitesse d'une pompe ou en réduisant l'ouverture d'une vanne de contrôle, pour réduire la vitesse de pompage et réduire en conséquence la vitesse de diminution de la pression Pₑₓₜ dans l'enceinte étanche 9. De façon idéale, les moyens de commande 14 réduisent la vitesse de pompage de telle manière que la déformation d reste en palier, au voisinage de la limite D, jusqu'en fin d'étape de pompage. On voit alors, sur la figure 3, qu'entre les instants t₁ et t₂ la déformation d est sensiblement constante et la pression Pₑₓₜ décroît moins vite que lors de l'étape précédente entre les instants t₀ et t₁.

A l'instant t₂, on atteint la pression P₁ basse désirée dans l'enceinte étanche 9, ou pression appropriée pour l'opération de dépollution du photomasque 100. Les moyens de commande 14 reprennent alors le déroulement du programme normal, en réduisant le pompage et en pilotant les moyens de fourniture de gaz de purge 13 pour introduire un gaz de purge dans l'enceinte étanche 9. Il en résulte une remontée de la pression Pₑₓₜ, jusqu'à la pression atmosphérique Pₐ. Simultanément, la déformation d décroît jusqu'à s'annuler.

Si la remontée de pression Pₑₓₜ est trop rapide, la déformation d peut s'inverser et atteindre, en négatif, la limite D. L'algorithme enregistré du programme limite alors le débit des moyens de fourniture de gaz 13, pour éviter que la déformation d ne dépasse la limite D.

On notera que le dispositif peut gérer deux limites D⁺ et D- différentes. Par exemple, D⁺ peut être choisie un peu inférieure à la limite de déformation élastique de la membrane 1, pour éviter la rupture de la membrane 1, tandis que D-peut être choisie un peu inférieure à la distance entre la membrane 1 au repos et la surface du support 6, évitant le contact qui dégraderait l'état de surface et la qualité optique de la membrane 1.

La présente invention n'est pas limitée aux modes de réalisation qui ont été explicitement décrits, mais elle en inclut les diverses variantes et généralisations qui sont à la portée de l'homme du métier.

## Revendications

1. - Dispositif de nettoyage et de dépollution d'un objet (100) à environnement confiné non étanche limité par une paroi à membrane souple (1), comprenant :
- une enceinte (9) de nettoyage et de dépollution étanche munie d'une portion de paroi transparente (10) par laquelle peuvent entrer et sortir des faisceaux lumineux (l, 4) interagissant avec la membrane souple (1),
- des moyens de pompage (12),
- une source (13) de gaz de purge, contenant un gaz ou mélange de gaz de purge,
- une entrée pour relier à la source de gaz de purge (13) l'enceinte (9) de nettoyage et de dépollution,
- une sortie pour relier aux moyens de pompage (12) l'enceinte de nettoyage et de dépollution (9),
- des moyens de commande (14) pour piloter les moyens de pompage (12) et la source de gaz (13) de purge,
dans lequel les moyens de commande (14) pilotent les moyens de pompage (12) et/ou la source de gaz (13) de purge en fonction d'un signal (d) fourni par un dispositif de mesure sans contact de la déformation d'une membrane souple (1), transparente, fixe à ses extrémités et soumise à une pression différentielle, comprenant des moyens (3) pour générer un faisceau lumineux incident (I) et le diriger obliquement vers la membrane (1), et des moyens (5) pour recevoir et isoler le faisceau lumineux (4) réfléchi par la membrane (1) et pour en mesurer le déplacement.

2. - Dispositif selon la revendication 1, dans lequel le faisceau lumineux incident (I) fait avec la surface de la membrane (1) un angle d'incidence (α) d'environ 56°.

3. - Dispositif selon l'une des revendications 1 ou 2, dans lequel le faisceau lumineux incident (I) interagit avec la zone centrale de la membrane (1).

4. - Dispositif selon l'une des revendications 1 à 3, dans lequel les moyens (3) pour générer un faisceau lumineux incident (I) comprennent une source laser, avantageusement émettant un rayonnement à une longueur d'onde d'environ 900 nm.

5. - Dispositif selon l'une des revendications précédentes, dans lequel les moyens (5) pour recevoir et isoler le faisceau lumineux réfléchi (4) comprennent une matrice (5a) ordonnée de récepteurs photoélectriques (50a-51a) adaptée pour recevoir les faisceaux réfléchis par les différentes surfaces se trouvant sur le chemin du faisceau lumineux incident (1), comprenant le faisceau (4) réfléchi par la membrane (1), et pour produire des signaux électriques images de l'amplitude et de la position de l'énergie lumineuse atteignant la matrice (5a).

6. - Dispositif selon la revendication 5, dans lequel les moyens (5) pour recevoir et isoler le faisceau lumineux réfléchi (4) analysent les signaux électriques issus de la matrice (5a), distinguent, par sa position relative, le signal correspondant au faisceau (4) réfléchi par la membrane (1), et produisent en sortie un signal correspondant à la position du faisceau lumineux (4) réfléchi par la membrane (1).

7. - Dispositif selon l'une des revendications précédentes, dans lequel les moyens de commande (14) comprennent un processeur associé à un programme de commande enregistré dans une mémoire et comportant des séquences de programme d'extraction de gaz par pompage et des séquences de programme d'introduction de gaz de purge.

8. - Dispositif selon la revendication 7, dans lequel le programme contient un algorithme selon lequel :
- lorsque la déformation (d) de la membrane souple (1), mesurée par le dispositif de mesure sans contact, est inférieure à une limite (D) de déformation admissible, alors la séquence de pompage ou d'introduction de gaz de purge se déroule normalement,
- lorsque la déformation (d) de la membrane souple (1) mesurée par le capteur est au moins égale à la limite (D) de déformation admissible, la séquence de pompage ou d'introduction de gaz de purge est modifiée pour réduire volontairement la vitesse de variation de pression gazeuse Pₑₓₜ dans l'enceinte (9), afin de réduire ou de ne pas augmenter la déformation (d) de la membrane souple (1).

9. - Dispositif selon la revendication 8, dans lequel la limite de déformation admissible (D) est inférieure au seuil de déformation élastique de la membrane (1).

10. - Procédé de nettoyage et de dépollution d'un objet à environnement confiné non étanche (100) limité par une paroi à membrane souple (1) au moyen du dispositif selon l'une des revendications précédentes, comprenant les étapes suivantes :
- on place l'objet à environnement confiné non étanche (100) dans une enceinte étanche (9) comprenant des moyens (13) pour injecter un gaz ou mélange de gaz de purge et des moyens de pompage (12),
- on mesure en permanence la déformation (d) de la membrane (1) à l'aide d'un dispositif de mesure sans contact de la déformation d'une membrane souple (1), transparente, fixe à ses extrémités et soumise à une pression différentielle, qui comprend des moyens (3) pour générer un faisceau lumineux incident (I) et le diriger obliquement vers la membrane (1), et des moyens (5) pour recevoir et isoler le faisceau lumineux (4) réfléchi par la membrane (1) et pour en mesurer le déplacement,
- on pompe le gaz contenu dans l'enceinte étanche (9) et le gaz contenu dans l'espace intérieur de l'environnement confiné non étanche (100), et/ou on introduit un gaz de purge dans l'enceinte étanche (9) et dans l'espace intérieur de l'objet à environnement confiné non étanche (100),
- on contrôle le pompage et/ou l'introduction de gaz de purge en fonction du signal donné par le capteur, de manière à conserver la déformation (d) de la membrane (1) en deçà d'une limite de déformation admissible (D).
